Europäisches Patentamt

**European Patent Office**

**Office européen des brevets**

(11) Numéro de publication: **0 117 809**
**A1**

## DEMANDE DE BREVET EUROPEEN

(21) Numéro de dépôt: **84400337.6**

(51) Int. Cl.³: **H 05 K 3/36**

(22) Date de dépôt: **17.02.84**

(30) Priorité: **28.02.83 FR 8303247**

(43) Date de publication de la demande: **05.09.84**
**Bulletin 84/36**

(84) Etats contractants désignés: **DE GB NL**

(71) Demandeur: **COMPAGNIE D'INFORMATIOUE MILITAIRE SPATIALE ET AERONAUTIQUE, 25, rue de Courcelles, F-75008 Paris (FR)**

(72) Inventeur: **Servol, Jacques, THOMSON-CSF SCPI 173, bld Haussmann, F-75379 Paris Cedex 08 (FR)**
Inventeur: **Tonella, Claude, THOMSON-CSF SCPI 173, bld Haussmann, F-75379 Paris Cedex 08 (FR)**

(74) Mandataire: **Benoit, Monique et al, THOMSON-CSF SCPI 173, Bld Haussmann, F-75379 Paris Cedex 08 (FR)**

(54) **Dispositif de connexion électrique entre deux cartes de circuits imprimés, et procédé de connextion de deux cartes de circuits imprimés à l'aide d'un tel dispositif.**

(57) L'invention concerne un dispositif de connexion électrique entre deux cartes de circuits imprimés et un procédé de connexion de deux cartes de circuits imprimés à l'aide d'un tel dispositif.

Dispositif de connexion électrique entre deux cartes de circuits imprimés, chacune de ces deux cartes comportant au moins un trou métallisé et le dispositif de connexion étant réalisé à partir d'un matériau isolant souple comportant en plus des dépôts conducteurs formant des pistes sur toute sa longueur et connectées entre au moins deux trous métallisés (23) destinés à coopérer électriquement avec les trous métallisés (16) des cartes de circuits imprimés (4 et 5) et une couche de colle recouvrant partiellement la face située en regard des cartes de circuits imprimés, destinée à assurer la liaison mécanique avec celles-ci.

Procédé de connexion électrique entre deux cartes de circuits imprimés.

0117809

1

# DISPOSITIF DE CONNEXION ELECTRIQUE
# ENTRE DEUX CARTES DE CIRCUITS IMPRIMES ET
# PROCEDE DE CONNEXION DE DEUX CARTES DE CIRCUITS IMPRIMES
# A L'AIDE D'UN TEL DISPOSITIF

La présente invention concerne un dispositif de connexion électrique entre deux cartes de circuits imprimés et un procédé de connexion de deux cartes de circuits imprimés à l'aide d'un tel dispositif.

Actuellement, il existe essentiellement deux méthodes de connexion entre deux cartes de circuits imprimés, que ces cartes soient simple ou double face ou bien encore multicouches, autrement dit qu'elles comportent une ou deux faces recouvertes de dépôts conducteurs ou bien encore qu'elles soient constituées de plusieurs couches de matériau isolant recouvertes chacune de dépôts conducteurs. La première méthode consiste à utiliser un câblage filaire, c'est-à-dire un réseau de fils électriques de différents diamètres groupés en torons, brasés, sertis ou en nappe de connexion enroulée, dite nappe de "Wrapping" selon le vocable anglo-saxon, pour assurer les liaisons électriques. Le principal inconvénient de cette méthode est le trop grand encombrement de ces fils dans des matériels que l'on veut de plus en plus compacts, c'est à dire ayant des dimensions de plus en plus réduites, et denses c'est-à-dire comportant de plus en plus de cartes de circuits imprimés placés à l'intérieur.

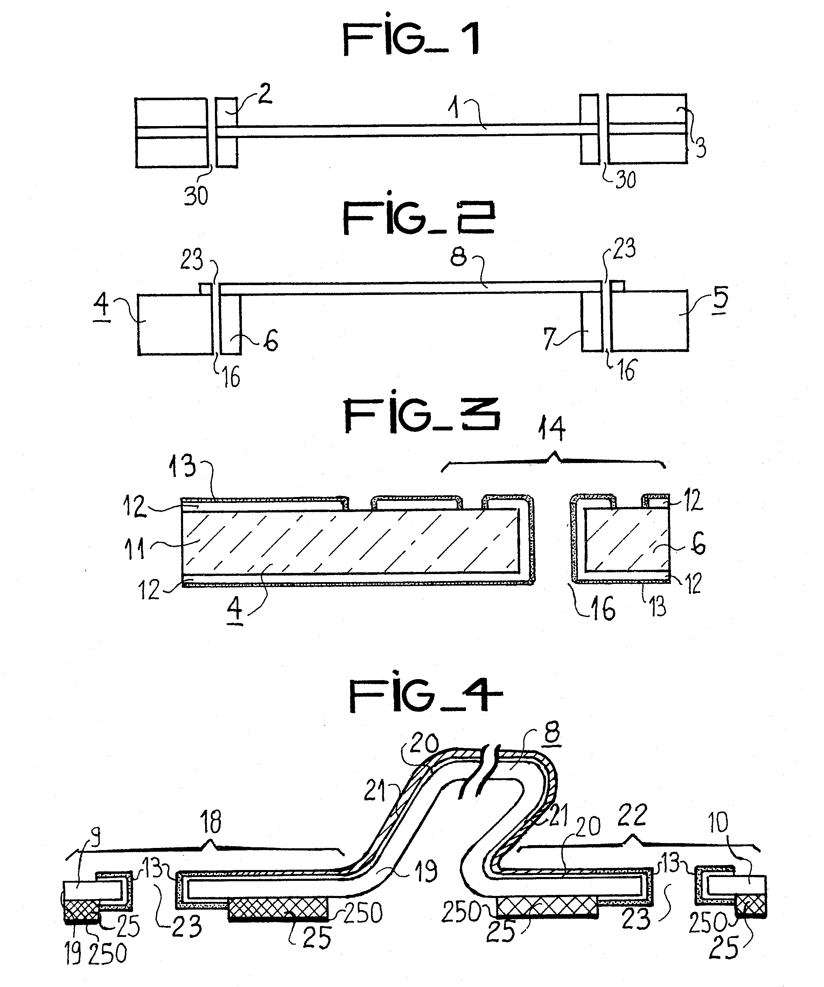

Pour pallier cet inconvénient, il existe une seconde méthode qui consiste à utiliser des circuits dits flex-rigides qui se composent d'au moins deux cartes de circuits imprimés relativement rigides et d'un circuit de liaison électrique plus souple que ces dernières.Ces cartes peuvent être simple ou double face ou bien multicouches, tout comme le circuit de liaison électrique, celui-ci devant cependant garder une certaine souplesse. La figure 1 représente un cas particulier de réalisation de circuits flex-rigides selon l'art antérieur, pour lequel les cartes de circuits imprimés 2 et 3 à relier électriquement sont multicouches. Le dispositif 1 de liaison souple est généralement constitué à partir d'un matériau isolant souple, du type Kapton ou FR 4, recouvert de pistes conductrices sur toute sa longueur de façon à réaliser les liaisons électriques entre les deux cartes à relier. Ce type de matériau se fixe très mal et nécessite une préparation chimique pour pouvoir être fixé, par un procédé traditionnel de stratification, entre les couches de matériau isolant, du type verre résine-époxy, constituant les différentes couches de cartes de circuits imprimés.

Ainsi les liaisons mécaniques entre les cartes d'une part et le dispositif de liaison d'autre part sont assurées par stratification des différentes couches et les liaisons électriques sont assurées par la présence de trous métallisés 30, percés à travers toute l'épaisseur de chaque carte à l'intérieur de laquelle est disposée une des deux extrémités du dispositif de liaison.

Cette seconde méthode présente essentiellement trois inconvénients. Premièrement, il existe des difficultés au niveau de l'élaboration de cet ensemble cartes de circuits imprimés - dispositif de liaison électrique souple, du même type que pour une carte multicouche. Deuxièmement, il existe des difficultés de fabrication car les procédés de fabrication d'un circuit multicouche ne sont pas compatibles avec ceux d'un circuit imprimé traditionnel, et des difficultés de modification, car on ne peut corriger un des éléments d'un circuit flex-rigide sans refaire un circuit complet. A l'heure actuelle, les réalisations de circuit du type flex-rigides sont élaborées toujours dans des laboratoires d'études et/ou de prototypes, qui ne peuvent être aisément développees dans des chaînes de fabrication série. Enfin, troisièmement, le coût actuel de cet ensemble est relativement élevé et dissuasif pour les utilisateurs.

Le but de la présente invention est de pallier notamment ces

3 0117809

divers inconvénients et son objet est un dispositif de connexion électrique entre deux cartes de circuits imprimés, chacune de ces deux cartes comportant au moins un trou métallisé et le dispositif de connexion étant réalisé à partir d'un matériau isolant souple, caractérisé en ce qu'il comporte en plus des dépôts conducteurs formant des pistes sur toute sa longueur et connectés entre au moins deux trous métallisés destinés à coopérer électriquement avec les trous métallisés des cartes de circuits imprimés et une couche de colle recouvrant partiellement la face située en regard des cartes de circuits imprimés, destinée à assurer la liaison mécanique avec celles-ci.

L'avantage de ce dispositif ainsi réalisé est qu'il est de réalisation simple, car aussi bien le dispositif de liaison souple que les cartes de circuits imprimés à relier sont des éléments simples standards, pouvant être intégrés dans une chaîne de production industrielle, permettant en conséquence un abaissement des coûts de fabrication.

D'autres caractéristiques et avantages de l'invention apparaîtront dans la description qui suit, illustrée par les figures suivantes qui, outre la figure 1 déjà décrite, représentent :

- la figure 2 : un schéma simplifié de l'objet de l'invention;

- la figure 3 : une vue en coupe transversale d'une carte double face de circuit imprimé devant être connectée au dispositif selon l'invention ;

- la figure 4 : une vue en coupe transversale du dispositif de liaison souple selon l'invention;

- la figure 5 : une vue en coupe transversale de l'ensemble constitué par les cartes de circuits imprimés et leur dispositif de liaison souple selon l'invention;

- les figures 6a et 6b : des vues respectivement de dessus et en coupe transversale d'une zone de liaison terminale d'une carte de circuit imprimé;

- les figures 7a et 7b : des vues respectivement de dessous et en coupe transversale d'une zone de liaison terminale du dispositif de liaison souple.

Les éléments assurant les mêmes fonctions en vue des mêmes résultats sont référencés identiquement dans les différentes figures.

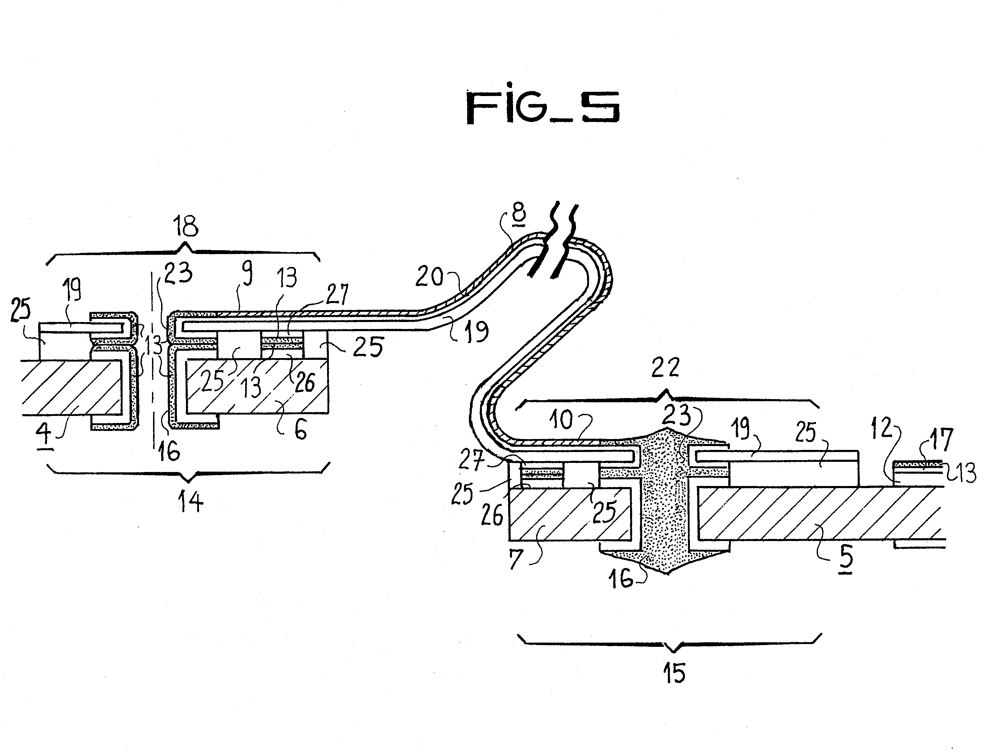

La figure 2 représente un schéma simplifié du dispositif de liaison électrique souple, objet de l'invention, connectant entre elles deux cartes de circuits imprimés 4 et 5.

Le dispositif de liaison 8 est constitué d'une seule couche de matériau isolant souple, comportant des dépôts conducteurs formant des pistes sur une ou deux faces opposées l'une à l'autre, ou bien de plusieurs couches empilées, comportant à chacune de ses extrémités au moins un trou métallisé 23 et une couche de colle.

Les cartes de circuits imprimés 4 et 5 sont simple ou double face ou bien encore multicouches et présentent chacune à une de leurs extrémités respectives 6 et 7 au moins un trou métallisé 16.

Le raccordement entre les cartes 4 et 5 et le dispositif souple 8 se fait par coïncidence des trous métallisés 16 et 23 et collage au moyen de la couche de colle placée sur la face du dispositif 8 en regard des cartes à raccorder.

La figure 3 est un exemple non limitatif de carte de circuits imprimés pouvant être reliée par le dispositif de liaison électrique souple selon l'invention. Elle représente une vue en coupe transversale d'une carte double face 4 de circuits imprimés, réalisée à partir d'un substrat isolant 11 du type verre résine-époxy, recouvert sur chacune de ses deux faces opposées l'une à l'autre d'une couche 12 de matériau conducteur, réalisant les pistes du circuit imprimé, revêtue d'une couche protectrice 13 évitant l'oxydation - généralement d'étain-plomb - et permettant des opérations de brasage. Cette carte 4 comporte à une de ses extrémités 6 une zone dite de liaison 14 comprenant des trous métallisés 16 dont la métallisation est obtenue par dépôt de matériau conducteur recouvert d'une couche 13 d'étain-plomb.

Le dispositif de liaison électrique souple 8 représenté en coupe transversale sur la figure 4 est réalisé à partir d'une carte souple de circuit imprimé comprenant un substrat isolant 19. Ce substrat isolant 19 peut être généralement simple ou double face ou même comporter plusieurs couches entre lesquelles sont intercalées des pistes conductrices ; cependant son épaisseur est notablement plus faible que celle des cartes de circuits imprimés à relier électriquement car il doit présenter une certaine souplesse. Dans le cas particulier de la figure 4, ce substrat isolant 19 n'est recouvert que sur une première face de dépôts conducteurs 20 formant sur toute sa longueur les pistes de ce circuit imprimé. Eventuellement, ces dépôts 20 peuvent être revêtus par une couche 21 protectrice. A chacune des deux extrémités 9 et 10 de ce dispositif de liaison 8, est définie une zone de liaison terminale 18 et 22 comprenant d'une part des trous métallisés 23 dont la métallisation est obtenue par dépôt de matériau conducteur recouvert d'une couche 13 de protection et d'aide au brasage, et d'autre part une couche de matériau à transfert d'adhésif 25 - autrement appelé adhésif transfert - recouvrant la seconde face du substrat 19 opposé à la première. On appelle matériau à transfert d'adhésif, une colle pure, sans agent de support. Pour maintenir les qualités de l'adhésif et faciliter les manipulations du dispositif de liaison souple 8, cette couche d'adhésif est recouverte d'un film protecteur 250, autrement appelé intercalaire.

La connexion entre les deux cartes 4 et 5 et ce dispositif de liaison électrique souple 8 se fait par raccordement de leurs zones de liaison respectives, comme le montre la figure 5. Comme cela a été précisé auparavant, les différents éléments composant les deux cartes 4 et 5 de circuits imprimés à relier électriquement portent les mêmes références car remplissent les mêmes fonctions en vue des mêmes résultats. Les deux zones de liaison terminales 18 et 22 du dispositif de liaison souple 8 sont placées en vis à vis des zones de liaison 14 et 15 des cartes double face 4 et 5 de façon telle que les trous métallisés 23 du dispositif 8 coïncident avec ceux 16 des cartes 4 et 5. Une fois ces zones de liaison placées en coïncidence, la liaison mécanique entre les dispositifs de liaison souple 8 et les cartes 4 et 5 est obtenue par collage - par simple pression - au moyen de l'adhésif transfert sur les cartes double face et les liaisons électriques sont réalisées par brasage tendre - généralement à l'étain plomb - sur la face des cartes 4 et 5 opposées à celles collée au dispositif de liaison souple 8. Il peut s'agir de brasage tendre par apport d'étain plomb, manuel ou à la vague, ou bien encore par refusion de la couche protectrice 13 d'étain plomb recouvrant le matériau conducteur, en élevant la température en infra-rouge ou en phase vapeur. On notera que ce brasage réalise non seulement les liaisons électriques entre les pistes conductrices à la fois des cartes de circuits imprimés et du dispositif souple mais améliore aussi leur liaison mécanique déjà réalisée par collage au moyen du matériau à transfert d'adhésif. Sur la figure 5, la liaison entre la carte de circuit imprimé 4 et le dispositif souple 8 est essentiellement mécanique, par collage au moyen de l'adhésif transfert, la liaison électrique entre les pistes conductrices au moyen de trous métallisés 16 et 23 placés en coïncidence n'étant pas encore réalisée. Par contre, en ce qui concerne le raccordement des zones de liaison respectives 15 et 22, le brasage a été effectué, reliant électriquement les trous 16 et 23 et par conséquent les différentes pistes des circuits imprimés.

La référence 17 concerne une piste conductrice déposée sur la carte de circuits imprimés 5 et ne faisant pas partie de la zone de liaison 22 avec le dispositif souple 8.

Pour améliorer la connexion entre les différents éléments constituant l'objet de l'invention et qui viennent d'être décrits, leurs zones de liaison peuvent présenter en plus des zones de maintien mécanique respectives 26 et 27 constituées de dépôts de matériau conducteur recouverts eux aussi d'une couche protectrice 13 évitant l'oxydation et aidant au brasage. Ces dépôts sont placés en regard les uns des autres sur les faces respectives des cartes 4 et 5 et du dispositif de liaison souple 8 collées l'une sur l'autre. La liaison mécanique est obtenue lors d'un procédé de brasage tendre par refusion de la couche 13 d'étain-plomb généralement en phase vapeur. Ainsi, les dépôts conducteurs de ces zones de maintien mécanique 26 et 27 sont brasés en même temps que sont reliés électriquement les trous 16 et 23 respectivement des cartes à connecter et du dispositif de liaison.

La figure 6a représente une zone de liaison 14 d'une carte double face 4 de circuit imprimé en vue de dessus et la figure 6b la représente vue transversalement. Cette zone de liaison 14 comporte des trous métallisés 16 et un dépôt de matériau conducteur 26 recouvert d'une couche d'étain-plomb 13, réalisant la zone de maintien mécanique, déposé sur la face de la carte 4 qui sera placée en regard de la face collante du dispositif de liaison électrique souple.

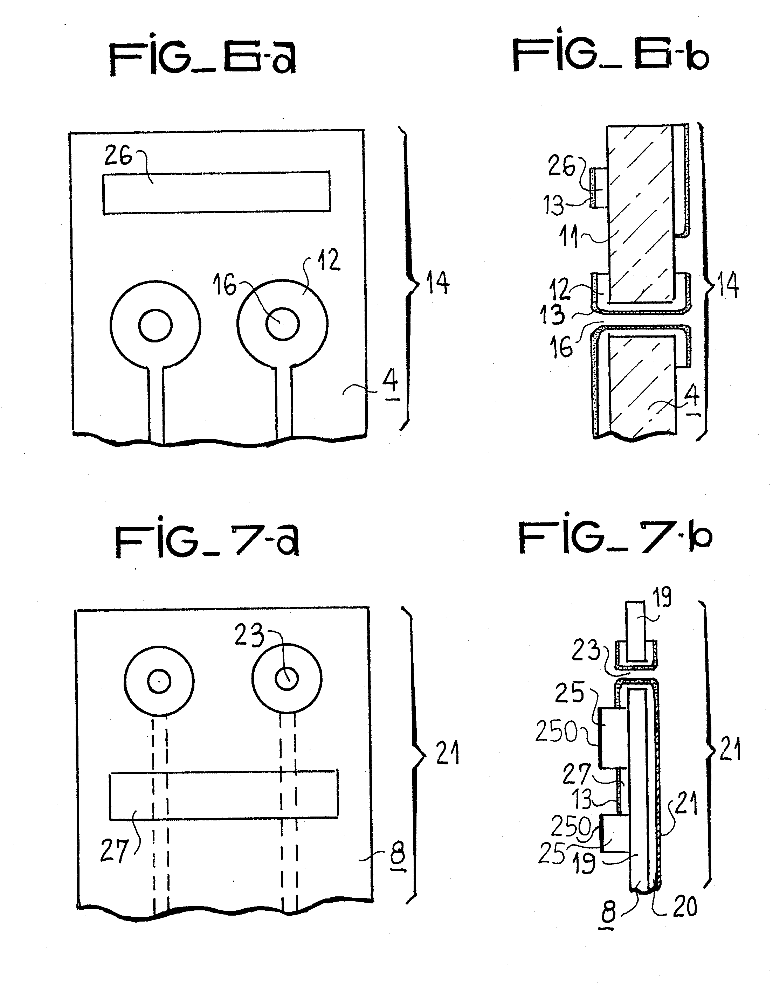

La figure 7a représente une zone de liaison terminale 21 d'une des deux extrémités du dispositif de liaison souple 8, vue de dessous et la figure 7b la représente transversalement. Cette zone de liaison 21 comporte des trous métallisés 23 et un dépôt de matériau conducteur 27 recouvert d'une couche d'étain-plomb 13, sur la face du dispositif souple qui comporte le matériau adhésif transfert 25 et sera placée en regard de la face de la carte de circuits imprimés à relier. Au moment de la conception de l'ensemble constitué par les deux cartes et le dispositif de liaison souple, l'emplacement des trous métallisés et des zones de maintien mécanique est étudié pour obtenir une parfaite coïncidence au moment du raccordement.

La présente invention concerne également un procédé de connexion entre deux cartes de circuits imprimés comprenant chacune au moins un trou métallisé au moyen d'un dispositif tel que décrit auparavant, ce dispositif ainsi que les cartes à connecter électriquement n'ayant pas de zones de maintien mécanique 26 et 27 supplémentaire. Ce procédé comporte les étapes suivantes :

- une première étape de mise des trous 16 des cartes de circuits imprimés 4 et 5 en coïncidence avec ceux 23 du dispositif souple 8 ;

- une seconde étape de maintien mécanique par collage du dispositif souple 8 sur les cartes de circuits imprimés 4 et 5 au moyen de la couche d'adhésif transfert 25 ;

8

0117809

- une troisième étape de connexion électrique par brasage manuel ou à la vague des trous métallisés 16 et 23.

Dans le cas de réalisation préférentielle où le dispositif de connexion et les cartes comportent des zones de maintien mécanique, l'étape de connexion électrique du procédé précédent est remplacée par une étape de brasage par refusion - d'étain plomb par exemple - à haute température, des trous métallisés respectivement du dispositif et des cartes et des dépôts conducteurs constituant les zones de maintien mécanique.

REVENDICATIONS

1. Dispositif de connexion électrique entre deux cartes de circuits imprimés, chacune de ces deux cartes comportant au moins un trou métallisé et le dispositif de connexion étant réalisé à partir d'un matériau isolant souple, caractérisé en ce qu'il comporte en plus :

- des dépôts conducteurs formant des pistes sur toute sa longueur et entre au moins deux trous métallisés (23) destinés à coopérer électriquement avec les trous métallisés (16) des cartes de circuits imprimés (4 et 5) et

- une couche de colle recouvrant partiellement la partie de la face du dispositif située en regard de chacune des cartes de circuits imprimés, destinée à assurer la liaison mécanique avec celles-ci.

2. Dispositif selon la revendication 1, caractérisé en ce que la couche de colle est une couche de matériau à transfert d'adhésif (25).

3. Dispositif selon la revendication 1 ou 2, caractérisé en ce qu'il comporte de plus des zones de maintien mécanique (27) placées sur la même face que la couche de colle et destinées à coopérer avec des zones de maintien mécanique (26) disposées sur les cartes de circuits imprimés (4 et 5), en regard les unes des autres.

4. Dispositif selon la revendication 1, 2 ou 3, caractérisé en ce que les zones de maintien mécanique (26 et 27) comportent des dépôts de matériau conducteur, recouverts d'une couche protectrice (13) évitant l'oxydation et permettant les opérations de brasage.

5. Dispositif selon l'une des revendications 1 à 4, caractérisé en ce qu'il comporte une ou plusieurs couches de matériau isolant souple, recouverts de dépôts conducteurs formant des pistes de circuit imprimé.

6. Procédé de connexion électrique entre deux cartes de circuits imprimés (4 et 5) comprenant chacune au moins un trou

0117809

métallisé (16) au moyen d'un dispositif de connexion (8) réalisé selon l'une quelconque des revendications 1, 2 et 5, caractérisé en ce qu'il comporte :

- une première étape de mise des trous (16) des cartes de circuits imprimés (4 et 5) en coïncidence avec ceux (23) du dispositif souple (8) ;

- une seconde étape de maintien mécanique par collage du dispositif souple (8) sur les cartes de circuits imprimés (4 et 5) au moyen de la couche de colle (25);

- une troisième étape de connexion électrique par brasage ou à la vague des trous métallisés (16 et 23).

7. Procédé de connexion électrique entre deux cartes de circuits imprimés (4 et 5) comprenant chacune au moins un trou métallisé (16) au moyen d'un dispositif de connexion (8) réalisé selon l'une quelconque des revendications 1 à 5, caractérisé en ce qu'il comporte :

- une première étape de mise des trous (16) des cartes de circuits imprimés (4 et 5) en coïncidence avec ceux (23) du dispositif souple (8);

- une seconde étape de maintien mécanique par collage du dispositif souple (8) sur les cartes de circuits imprimés (4 et 5) au moyen de la couche d'adhésif transfert (25);

- une troisième étape de connexion électrique et de maintien mécanique par brasage par refusion à haute température, des trous métallisés (23 et 16) respectivement du dispositif (8) et des cartes (4 et 5) et des dépôts conducteurs constituant les zones de maintien mécanique (26 et 27).

# FIG_1

2
1
3
30
30

# FIG_2

23
8
23
4
5
6
16
7
16

# FIG_3

14
13
12
11
12
4
12
6
12
16
13

# FIG_4

20
8
21
21
20
22
18
10
9
19
13
23
250
25
19 250
25
250
25
13
250
25

# FIG_5

0117809

## FIG_6a

26

16   12

14

4

## FIG_6b

26
13
11

12
13

16

14

4

## FIG_7a

23

21

27

8

## FIG_7b

19

23

25
250

27
13

250
25
19

21

21

8   20

Office européen
des brevets

**RAPPORT DE RECHERCHE EUROPEENNE**

0117809
Numéro de la demande

EP    84 40 0337

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | FR-A-2 362 556  (THOMSON-CSF)<br>* Figure 1; page 2, lignes 22-28 * | 1,5 | H 05 K    3/36 |
| | --- | | |
| A | FR-A-2 453 509  (GERMAR)<br>* Figures 1,3,5; page 3, ligne 26 - page 5, ligne 28 * | 1,2,5 | |
| | --- | | |
| A | GB-A-1 391 782  (PLESSEY COMP.)<br>* Figure 1; page 2, lignes 84-97 * | 1 | |
| | --- | | |
| A | GB-A-1 136 753  (ENGLISH ELECTRIC COMPUTERS)<br>* Figures 4,5; page 2, ligne 87 - page 3, ligne 8 * | 1,3,6, 7 | |
| | --- | | DOMAINES TECHNIQUES RECHERCHES (Int. Cl. ³) |
| A | FR-A-2 247 048  (M. PIAT & G. PFISTER)<br>* Figure 3; page 4, lignes 24-33 * | 1,6,7 | H 01 R    9/00<br>H 05 K    1/00<br>H 05 K    3/00 |
| | ----- | | |

Le présent rapport de recherche a été établi pour toutes les revendications

| Lieu de la recherche | Date d'achèvement de la recherche | Examinateur |
|---|---|---|
| LA HAYE | 12-04-1984 | WAERN G.M. |